# EUROPEAN PATENT APPLICATION

(11) **EP 3 179 282 A1**
(43) Date of publication of application: **14.06.2017**
(21) Application number: 15829423.1
(22) Date of filing: 03.08.2015
(51) Int. Cl.: G02B 5/26, B32B 7/02, B32B 15/01, G02B 5/22

(54) **INFRARED REFLECTING SUBSTRATE**

(30) Priority: 05.08.2014 JP 2014159889
(71) Applicant: Nitto Denko Corporation, Ibaraki-shi, Osaka 567-8680 (JP)
(72) Inventor: NAKANISHI, Yosuke, Ibaraki-shi Osaka 567-8680 (JP); WATANABE, Masahiko, Ibaraki-shi Osaka 567-8680 (JP); OHMORI, Yutaka, Ibaraki-shi Osaka 567-8680 (JP)
(74) Representative: Gill Jennings & Every LLP
(86) International application number: PCT/JP2015/071921
(87) International publication number: WO 2016/021532

(57) **Abstract**

Infrared reflecting substrate (100) includes, on a transparent film base (10), an infrared reflecting layer (23) mainly made of silver and a light absorptive metal layer (25) in this order. The light absorptive metal layer (25) has a thickness of 15 nm or less, and a transparent protective layer (30) has a thickness of 10 nm to 120 nm. The distance between the light absorptive metal layer (25) and the transparent protective layer (30) is 25 nm or less. The infrared reflecting substrate having low visible light reflectance, excellent visibility and excellent productivity is provided by the present invention.

## Description

### TECHNICAL FIELD

The invention relates to an infrared reflecting substrate having thin-films including infrared reflecting layer etc. on a transparent substrate.

### BACKGROUND ART

Heretofore, an infrared reflecting substrate having an infrared reflecting layer on a substrate of glass, film or the like is known. As the infrared reflecting layer, a metal layer such as silver is widely used. In an infrared reflecting substrate, a configuration is widely adopted in which a metal layer serving as an infrared reflecting layer and a metal oxide layer are alternately stacked, in order to ensure transparency by transmitting visible light while reflecting infrared rays. By adjusting the thicknesses of the metal layer and the metal oxide layer, the transmittance and the reflectance can be allowed to have wavelength selectivity, whereby an infrared reflecting substrate can be obtained that is capable of selectively reflecting infrared rays and selectively transmitting visible light. Further, in the infrared reflecting substrate, a transparent protective layer (top coat layer) made of resin is generally provided, in order to chemically protect the metal layer and others formed on the substrate.

In the infrared reflecting substrate, the metal layer of silver or the like reflects near-infrared rays such as solar light to impart heat shielding properties. On the other hand, in order to allow the infrared reflecting substrate to have heat insulating properties, it is important to reduce the emittance and to reflect far-infrared rays to the interior of a room by the infrared reflecting layer. Since a resin layer (organic material) used as the transparent protective layer of the infrared reflecting layer generally contains C=C bonds, C=O bonds, C-O bonds or aromatic rings, infrared vibration absorption of a far-infrared ray region of a wavelength of 5 µm to 25 µm is large. The far-infrared ray absorbed at the resin layer is dissipated outdoors as heat due to thermal conduction without being reflected at the metal layer.

For the purpose of reducing the emittance of the infrared reflecting substrate, Patent Document 1 proposes a method of using a protective layer made of an Si-based material such as polysilazane, fluoroalkylsilane, or fluorosilane and setting the thickness thereof to be 500 nm or less to reduce the amount of far-infrared ray absorption caused by the protective layer. On the other hand, when the thickness of the protective layer is reduced, a chemical protecting effect on the infrared reflecting layer tends to decrease thereby leading to decrease in the durability of the infrared reflecting layer. In particular, silver is low in durability against oxygen, moisture, chlorine, and the like, so that, when an infrared reflecting layer mainly made of silver is degraded, the emittance of the infrared reflecting substrate tends to rise (the heat insulating properties decrease). For this reason, Patent Document 1 proposes to improve the durability of the infrared reflecting layer by adopting a configuration in which the infrared reflecting layer made of a metal such as silver is interposed between metal layers having a high durability such as a Ni-Cr alloy.

In an infrared reflecting substrate having a configuration in which a metal layer and a metal oxide layer are alternately stacked, it is difficult to completely suppress the reflection of visible light, so that there are some cases in which the reflection of visible light leads to decrease in the visibility. In particular, when the infrared reflecting substrate is used for a store window, a display case or the like, decrease in the visibility caused by reflection of visible light can be a considerable problem. In order to cope with this, by disposing a light absorptive metal layer such as a Ni-Cr alloy on a metal layer serving as an infrared reflecting layer as proposed in Patent Document 1, the reflection of visible light can be reduced, thereby improving the visibility.

Patent Document 2 discloses a configuration in which an infrared reflecting substrate is provided with a Fabry-Pérot interference stack, to reduce the reflectance of visible light. In the Fabry-Pérot interference stack, a spacer layer is interposed between two metal layers (mirror layers) and, by adjusting the optical thickness of the spacer layer, light of a predetermined wavelength range can be selectively transmitted, and light of other wavelength ranges can be reflected.

### PRIOR ART DOCUMENTS

### PATENT DOCUMENTS

Patent Document 1: WO2011/109306 (FIG. 2 and others)
Patent Document 2: WO2004/017700

### SUMMARY OF THE INVENTION

### PROBLEMS TO BE SOLVED BY THE INVENTION

A configuration in which a light absorptive metal layer is disposed on an infrared reflecting layer, as disclosed in Patent Document 1, is useful because the durability of the infrared reflecting layer can be enhanced, while the reflectance of visible light can be reduced. However, since the reduction of reflectance by the light absorptive metal layer is mainly derived from absorption of visible light, there is a problem in that, when the thickness of the light absorptive metal layer is increased, the visible light transmittance decreases, thereby leading to loss of transparency.

As a method of reducing the reflectance of visible light while suppressing the decrease of transparency, there is a method of increasing the number of stacking the metal layers and the metal oxide layers, for example. The larger the number of stacking the layers is, the more exactly the wavelength selectivity of the reflectance can be controlled, so that the reflectance of visible light can be reduced to improve the visibility while increasing the reflectance of infrared rays to enhance the heat shielding properties and the heat insulating properties. However, increase in the number of stacking the layers raises a problem of decrease in the productivity or increase in the costs.

In the infrared reflecting substrate disclosed in Patent Document 1, a spacer layer made of a metal oxide having a thickness of about 40 nm to 80 nm and a silicon base layer made of a silicon-based alloy such as silicon nitride, silicon oxide, or silicon oxide nitride having a thickness of about 10 nm are further disposed between the metal layer of Ni-Cr or the like and the protective layer. Although the role of the spacer layer and the base layer is not clearly described in Patent Document 1, it seems that these layers are disposed for the purpose of adjusting the reflectance and the transmittance of the infrared reflecting substrate by using the Fabry-Pérot interference disclosed in Patent Document 2 and the like.

In order to transmit visible light and reflect infrared rays by the Fabry-Perot interference, it is necessary to set the optical thickness of the spacer layer to be about 100 nm or more. Since metal oxides and silicon-based alloys have a refractive index of about 1.7 to 2.3, a physical thickness of about 50 nm is needed in setting the optical thickness of the spacer layer to be about 100 nm or more. Since the metal oxides and silicon-based alloys have a low electric conductivity and thus the sputtering deposition rate is low, deposition of a spacer layer having a thickness of about 50 nm can cause decrease in the productivity or increase in the costs.

Thus, in a conventional infrared reflecting substrate, in order to enhance the wavelength selectivity of reflectance to improve the visibility, there has been a need to increase the number of stacking the metal oxide layers and the like or to increase the thickness thereof at the sacrifice of productivity or costs. In view of the above-described situation, an object of the present invention is to provide an infrared reflecting substrate having low visible light reflectance, excellent visibility and excellent productivity without increasing the thickness of the metal oxide layer and the like between the infrared reflecting layer and the transparent protective layer.

### MEANS FOR SOLVING THE PROBLEMS

In view of the above, the present inventors have made eager investigations and consequently have found out that, by adjusting the thickness of the transparent protective layer (top coat layer) formed on a surface of the infrared reflecting substrate, an effect of reducing the visible light reflectance can be imparted in addition to the chemical effect of protecting the infrared reflecting layer. By this, the present inventors have found out that an infrared reflecting substrate with reduced visible light reflectance can be obtained even in a case where the thickness of the metal oxide layer and the like between the metal layer and the transparent protective layer is small or in a configuration in which the metal layer and the transparent protective layer are in direct contact with each other, leading to completion of the present invention.

The present invention relates to an infrared reflecting substrate including, on a transparent substrate, an infrared reflecting layer mainly made of silver, a light absorptive metal layer, and a transparent protective layer in this order. In the infrared reflecting substrate of the present invention, it is preferable that the thickness of the light absorptive metal layer is 15 nm or less. The distance between the light absorptive metal layer and the transparent protective layer is preferably 25 nm or less. Glass, a flexible transparent film or the like is used as the transparent substrate. From the viewpoint of enhancing the productivity of the infrared reflecting film, a flexible transparent film is preferably used as the transparent substrate.

The transparent protective layer preferably has a thickness of 10 nm to 120 nm. Further, the transparent protective layer preferably has an optical thickness of 50 nm to 150 nm, the optical thickness being defined as a product of the refractive index and the thickness.

A metal layer mainly made of nickel, chromium, or a nickel-chromium alloy is preferably used as the light absorptive metal layer. A silver alloy layer containing 0.1 parts by weight to 10 parts by weight of palladium with respect to 100 parts by weight of silver is preferably used as the infrared reflecting layer.

In one embodiment of the infrared reflecting substrate, the light absorptive metal layer and the transparent protective layer are in direct contact with each other.

In another embodiment of the infrared reflecting substrate, a transparent inorganic layer mainly made of a metal oxide, a metal nitride, or a metal oxide nitride is disposed between the light absorptive metal layer and the transparent protective layer. In this embodiment, it is preferable that the transparent inorganic layer and the transparent protective layer are in direct contact with each other. Further, it is preferable that the transparent inorganic layer and the metal layer are in direct contact with each other. The transparent inorganic layer is preferably a metal oxide layer, and above all in this case, a composite metal oxide containing zinc oxide and tin oxide is preferably used.

In one embodiment of an infrared reflecting substrate of the present invention, the transparent protective layer is an organic layer having a cross-linked structure derived from an ester compound having an acidic group and a polymerizable functional group in the same molecule. In this case, the content of the structure derived from the ester compound in the transparent protective layer is preferably 1 wt% to 20 wt%. As the ester compound, an ester compound of phosphoric acid and an organic acid having a polymerizable functional group is preferably used.

The transmittance of the infrared reflecting substrate of the present invention is preferably 15% to 50%.

### EFFECTS OF THE INVENTION

In the infrared reflecting substrate of the present invention, the visible light reflectance is reduced to provide a high visibility owing to the combination of light absorption by the light absorptive metal layer on the infrared reflecting layer and the anti-reflection effect produced by the transparent protective layer. Therefore, there is no need to provide a metal oxide layer or the like having a large thickness between the light absorptive metal layer and the transparent protective layer, so that the distance between the light absorptive metal layer and the transparent protective layer can be set to be 25 nm or less, thereby leading to excellent productivity.

### BRIEF DESCRIPTION OF THE DRAWINGS

FIG. 1 is a schematic cross-sectional view showing a stacking configuration of an infrared reflecting substrate according to one embodiment.
FIG. 2 is a schematic cross-sectional view showing a stacking configuration of an infrared reflecting substrate according to one embodiment.
FIG. 3 is a schematic cross-sectional view showing a usage example of an infrared reflecting substrate.

### MODE FOR CARRYING OUT THE INVENTION

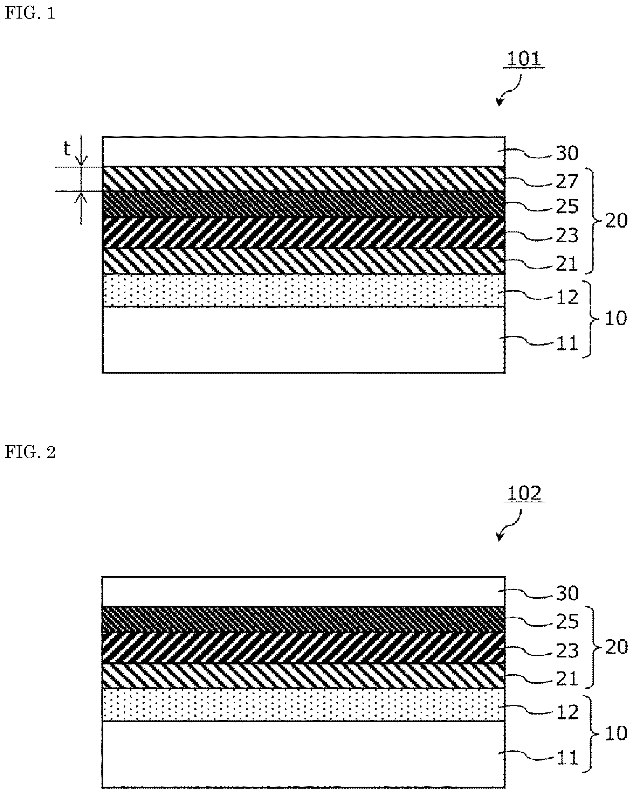

FIG. 1 is a schematic cross-sectional view showing a configuration example of an infrared reflecting substrate. As shown in FIG. 1, an infrared reflecting substrate 101 includes an infrared reflecting layer 23 on one principal surface of a transparent substrate 10. Referring to FIG. 1, a metal oxide layer 21 or the like may be present between the transparent substrate 10 and the infrared reflecting layer 23. Alternatively, the transparent substrate 10 and the infrared reflecting layer 23 may be in direct contact with each other.

A light absorptive metal layer 25 is formed on the infrared reflecting layer 23. In the embodiment shown in FIG. 1, a transparent protective layer 30 is formed on the light absorptive metal layer 25 with a transparent inorganic layer 27 interposed therebetween. In the infrared reflecting substrate of the present invention, the distance between the light absorptive metal layer and the transparent protective layer is 25 nm or less. In other words, in the embodiment shown in FIG. 1, the thickness t of the transparent inorganic layer 27 disposed between the light absorptive metal layer 25 and the transparent protective layer 30 is 25 nm or less.

In an infrared reflecting substrate 102 shown in FIG. 2, the transparent protective layer 30 is formed directly on the light absorptive metal layer 25. In the embodiment shown in FIG. 2, the distance between the light absorptive metal layer 25 and the transparent protective layer 30 is zero.

Thus, in the infrared reflecting substrate of the present invention, there are no other layers between the light absorptive metal layer 25 and the transparent protective layer 30, or else, even when a transparent inorganic layer 27 or the like is formed between the light absorptive metal layer 25 and the transparent protective layer 30, the thickness of the transparent inorganic layer 27 or the like is 25 nm or less. Thus, in the infrared reflecting substrate of the present invention, there is no need to form a metal oxide layer or the like having a large thickness on the metal layer in the production steps thereof, thereby providing an excellent productivity.

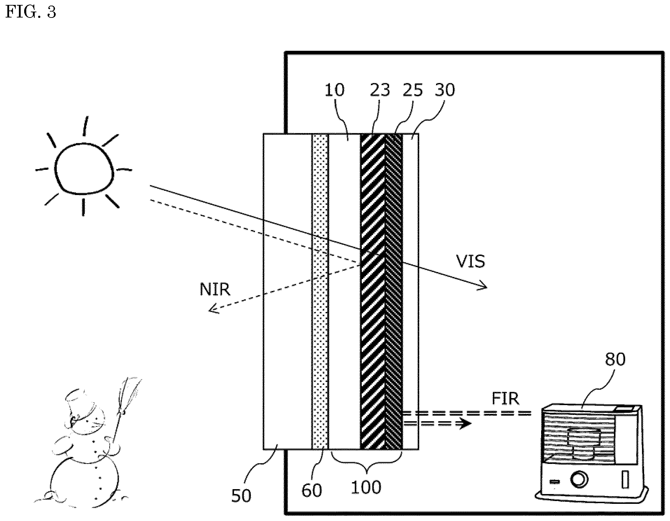

FIG. 3 is a schematic cross-sectional view showing a usage example of the infrared reflecting substrate. In this usage example, a transparent substrate 10 side of the infrared reflecting substrate 100 is bonded to a window 50 with an appropriate adhesive layer 60 interposed therebetween and the infrared reflecting substrate 100 is arranged on an interior side of a window 50 of buildings or automobiles to be used. As schematically shown in FIG. 3, the infrared reflecting substrate 100 transmits visible light (VIS) from the outdoors to introduce the light to the interior, and reflects near-infrared rays (NIR) from the outdoors at the infrared reflecting layer 23. Since heat flow from the outdoors to the interior resulting from sunlight or the like is suppressed (heat shielding effect is exerted) by the reflection of near-infrared rays, efficiency of the air conditioning in summer can be increased. Moreover, since the infrared reflecting layer reflects indoor far-infrared rays (FIR) emitted from a heating appliance 80 etc., a heat insulating effect is exerted and efficiency of heating in winter can be increased.

Hereinafter, preferred structures and materials for each layer are successively described.

### [Transparent Substrate]

As the transparent substrate 10, one having a visible light transmittance of 80% or more is suitably used. The visible light transmittance is measured according to JIS A 5759-2008 (Adhesive films for glazings).

The thickness of the transparent substrate 10 is not particularly limited, and it is, for example, about 10 µm to 10 mm. As the transparent substrate, a glass plate, a flexible transparent resin film or the like is used. Particularly, from the viewpoint of increasing the productivity of the infrared reflecting substrate and facilitating execution in bonding the infrared reflecting substrate to window glasses or the like, the flexible transparent resin film is suitably used. When the transparent resin film is used as the transparent substrate, its thickness is preferably in the range of about 10 µm to 300 µm. Further, since there may be cases where high temperature processes are performed in formation of metal layer, metal oxide layer and the like on the transparent substrate 10, a resin material constituting the transparent resin film substrate preferably has excellent heat resistance. Examples of the resin material constituting the transparent resin film substrate include polyethylene terephthalate (PET), polyethylene naphthalate (PEN), polyether ether ketone (PEEK), polycarbonate (PC) and the like.

When the transparent substrate 10 is a transparent resin film substrate, a transparent film 11 provided with a cured resin layer 12 on the film surface is suitably used for the purpose of increasing mechanical strength of the infrared reflecting substrate. Further, when a cured resin layer 12 is provided on the infrared reflecting layer 23-forming surface of the transparent film 11, abrasion-resistance of the infrared reflecting layer 23 and the transparent protective layer 30 formed thereon tends to be enhanced. The cured resin layer 12 can be formed, for example, by a method in which a cured coating of an appropriate ultraviolet-curable resin, such as acryl-based resin or silicone-based resin, is provided on the transparent film 11. The cured resin layer 12 with high hardness is suitably used.

For the purpose of increasing the adhesion, the infrared reflecting layer 23-forming surface of the transparent substrate 10 may be subjected to a surface modification treatment such as corona treatment, plasma treatment, flame treatment, ozone treatment, primer treatment, glow treatment, saponification treatment, or treatment with a coupling agent.

### [Infrared Reflecting Layer]

The infrared reflecting layer 23 is formed on the transparent substrate 10. The infrared reflecting layer 23 may be formed directly on the transparent substrate 10. Alternatively, referring to FIGS. 1 and 2, the metal oxide layer 21 or the like may be formed on the transparent substrate 10, and the infrared reflecting layer 23 may be formed thereon. The infrared reflecting layer 23 performs a function of imparting heat shielding properties by reflecting near-infrared rays and imparting heat insulating properties by reflecting far-infrared rays.

A metal layer composed mainly of silver is used as the infrared reflecting layer 23. Since silver has a high free electron density, it can realize a high reflectance of near-infrared rays and far-infrared rays to attain an infrared reflecting substrate which is excellent in the heat shielding effect and the heat insulating effect.

The content of silver in the infrared reflecting layer 23 is preferably 90 wt% or more, more preferably 93 wt% or more, further preferably 95 wt% or more. The wavelength selectivity of the transmittance and the reflectance can be enhanced and the visible light transmittance of the infrared reflecting substrate can be increased by increasing the content of silver in the metal layer.

The infrared reflecting layer 23 may be a silver alloy layer containing metal other than silver. For example, in order to increase the durability of the infrared reflecting layer, a silver alloy may be used. As the metal added for the purpose of increasing the durability, palladium (Pd), gold (Au), copper (Cu), bismuth (Bi), germanium (Ge), gallium (Ga) and the like are preferred. Among these metals, Pd is most suitably used from the viewpoint of imparting high durability to silver. When an addition amount of Pd or the like is increased, the durability of the metal layer tends to increase. When the infrared reflecting layer 23 contains metal such as Pd other than silver, the content of the metal is preferably 0.1 wt% or more, more preferably 0.5 wt% or more, further preferably 1 wt % or more, and particularly preferably 2 wt% or more. On the other hand, when the addition amount of Pd or the like is increased and the content of silver is decreased, the visible light transmittance of the infrared reflecting substrate tends to decrease. Therefore, the content of metal other than silver in the infrared reflecting layer 23 is preferably 10 wt% or less, more preferably 7 wt% or less, further preferably 5 wt% or less.

From the viewpoint of allowing the infrared reflecting substrate to have sufficient heat shielding properties and heat insulating properties, the thickness of the infrared reflecting layer 23 is preferably 3 nm or more, more preferably 5 nm or more, and further preferably 10 nm or more. An upper limit of the thickness of the infrared reflecting layer 23 is not particularly limited. In consideration of the visible light transmittance and the productivity, the thickness of the infrared reflecting layer 23 is preferably 30 nm or less, more preferably 25 nm or less, and further preferably 20 nm or less.

Although the method for forming the infrared reflecting layer 23 is not particularly limited, a dry process such as a sputtering method, a vacuum vapor deposition method, a CVD method or an electron-beam deposition method is preferred. Particularly, it is preferred to form the infrared reflecting layer 23 by the sputtering method.

### [Light Absorptive Metal Layer]

The light absorptive metal layer 25 is formed on the infrared reflecting layer 23. The light absorptive metal layer 25 functions as a protective layer for the infrared reflecting layer 23 and performs a function of reducing the visible light reflectance to enhance the visibility of a window glass or the like that is provided with the infrared reflecting substrate.

A metal layer mainly made of nickel (Ni), chromium (Cr) or a Ni-Cr alloy is preferably used as the light absorptive metal layer 25. These metals reduce the visible light reflectance of the infrared reflecting substrate by absorbing visible light and also can function as a protective layer for the infrared reflecting layer 23. Further, since these metals have low absorptivity of far-infrared rays, these metals perform a function of maintaining the emittance of the infrared reflecting substrate to be low, thereby enhancing the heat insulating properties. In the light absorptive metal layer 25, a sum of the content of Ni and the content of Cr is preferably 50 wt% or more, more preferably 60 wt%, further preferably 70 wt% or more, and particularly preferably 80 wt% or more. The light absorptive metal layer 25 is particularly preferably made of a Ni-Cr alloy in which the content of Ni and Cr is within the above range. The Ni-Cr alloy may contain other metals such as Ta, Ti, Fe, Mo, Co, Cu and W in addition to Ni and Cr.

The thickness of the light absorptive metal layer 25 is preferably 15 nm or less, more preferably 10 nm or less, further preferably 8 nm or less, and particularly preferably 6 nm or less. When the thickness of the light absorptive metal layer 25 is within the above range, absorption of visible light by the light absorptive metal layer does not increase excessively, so that the transparency of the infrared reflecting substrate is maintained. Further, when the thickness of the light absorptive metal layer exceeds 15 nm, visible light reflectance by multiple interference increases despite the fact that the absorption of visible light increases. In other words, when the thickness of the light absorptive metal layer is excessively large, the absorption and reflection of visible light increases and, in accordance therewith, the transmittance of visible light tends to decrease considerably, thereby lowering the visibility. From such a viewpoint as well, the thickness of the light absorptive metal layer is preferably 15 nm or less.

The thickness of the light absorptive metal layer 25 is preferably 2 nm or more, more preferably 3 nm or more. When the thickness of the light absorptive metal layer 25 is 2 nm or more, the property of protecting the infrared reflecting layer 23 is enhanced to suppress degradation of the infrared reflecting layer 23, and also the visibility of the infrared reflecting substrate is improved by reduction of the visible light reflectance.

Although the method for forming the light absorptive metal layer 25 is not particularly limited, a dry process such as a sputtering method, a vacuum vapor deposition method, a CVD method or an electron-beam deposition method is preferred. Particularly, it is preferred to form the light absorptive metal layer 25 by the sputtering method, as with the formation of the infrared reflecting layer 23.

### [Transparent Protective Layer]

The transparent protective layer 30 is disposed on the light absorptive metal layer 25 for the purpose of preventing abrasion of, and imparting a chemical protection function to, the infrared reflecting layer 23 and the light absorptive metal layer 25. The transparent protective layer 30 preferably has low absorption of far-infrared rays in addition to having a high visible light transmittance. When the absorption of far infrared rays is high, indoor far-infrared rays are absorbed by the transparent protective layer, and heat is dissipated to the outside by thermal conduction without being reflected by the infrared reflecting layer, so that the heat insulating properties tend to decrease. On the other hand, when the absorption of far-infrared rays by the transparent protective layer 30 is low, indoor far-infrared rays are reflected to the interior of the room by the infrared reflecting layer 23, so that the heat insulating properties are enhanced.

In the present invention, the thickness of the transparent protective layer 30 is 10 nm to 120 nm. When the thickness of the transparent protective layer is as small as 120 nm or less, there is little absorption of far-infrared rays by the transparent protective layer 30, so that the heat insulating properties by the infrared reflecting substrate are enhanced. Further, by setting the thickness of the transparent protective layer 30 to be 10 nm or more, the chemical durability and the abrasion resistance of the infrared reflecting layer 23 and the like are enhanced.

Furthermore, in the present invention, by setting the thickness of the transparent protective layer 30 to be within the above range, a function as an anti-reflection layer that decreases the visible light reflectance can be imparted by multiple reflection interference of the light reflected at the surface side of the transparent protective layer 30 and the light reflected at the interface on the light absorptive metal layer 25 side. Therefore, there is no need to form a metal oxide layer or the like having a large thickness on the infrared reflecting layer for the purpose of adjusting the visible light reflectance, so that the productivity of the infrared reflecting substrate is enhanced.

In order to reduce the visible light reflectance, an optical thickness (product of a refractive index and a physical thickness) of the transparent protective layer 30 is preferably 50 nm to 150 nm, more preferably 70 nm to 130 nm, and further preferably 80 nm to 120 nm. When the optical thickness of the transparent protective layer is in the above-mentioned range, an anti-reflection effect by the transparent protective layer is enhanced, and in addition to this, the appearance of the infrared reflecting substrate is improved since the optical thickness is smaller than a wavelength range of visible light and therefore "an iris phenomenon" that the surface of the infrared reflecting substrate gives the appearance of a rainbow pattern by the multiple reflection interference at an interface, is suppressed. Here, the refractive index is a value at a wavelength of 590 nm (wavelength of the Na-D line).

When the transparent protective layer is a resin layer, the refractive index thereof is typically about 1.3 to 1.7. Therefore, from the viewpoint of reducing the visible light reflectance by setting the optical thickness to be within the above range, the thickness of the transparent protective layer 30 is more preferably 40 nm to 100 nm, further preferably 50 nm to 90 nm, and particularly preferably 55 nm to 85 nm.

A material having a high visible light transmittance and being excellent in mechanical strength and chemical strength is preferable as a material of the transparent protective layer 30. A resin material is preferable from the viewpoint of preventing abrasion and enhancing the chemical protection function to the infrared reflecting layer and the light absorptive metal layer. As the resin material, active ray-curable or thermosetting organic resins such as fluorine-based, acryl-based, urethane-based, ester-based, epoxy-based and silicone-based resins; and organic-inorganic hybrid materials in which an organic component is chemically coupled with an inorganic component are preferably used.

It is preferred to introduce a cross-linked structure in the material of the transparent protective layer 30. When the cross-linked structure is formed, mechanical strength and chemical strength of the transparent protective layer are increased, and a function of protecting the infrared reflecting layer and the like is increased. Particularly, it is preferred to introduce a cross-linked structure derived from an ester compound having an acid group and a polymerizable functional group in one molecule.

Examples of the ester compound having an acid group and a polymerizable functional group in one molecule include esters of polyhydric acids such as phosphoric acid, sulfuric acid, oxalic acid, succinic acid, phthalic acid, fumaric acid and maleic acid; with a compound having, in a molecule, a hydroxyl group and a polymerizable functional group such as ethylenic unsaturated groups, silanol groups or epoxy groups. Although the polymerizable ester compound may be a polyhydric ester such as diester or triester, it is preferred that at least one acid group of a polyhydric acid is not esterified.

When the transparent protective layer 30 has a cross-linked structure derived from the above ester compound, the mechanical strength and the chemical strength of the transparent protective layer are enhanced, and further the adhesion between the transparent protective layer 30 and the light absorptive metal layer 25 or between the transparent protective layer 30 and the transparent inorganic layer 27 is enhanced, so that the durability of the infrared reflecting layer can be enhanced. Among the above ester compounds, an ester compound of phosphoric acid and an organic acid having a polymerizable functional group (phosphate ester compound) is excellent in adhesion to the metal layer or the metal oxide layer. In particular, a transparent protective layer having a cross-linked structure derived from a phosphate ester compound is excellent in adhesion to the metal oxide layer. Therefore, when the transparent protective layer 30 has a cross-linked structure derived from a phosphate ester compound, it is preferable that, in the infrared reflecting substrate, a transparent inorganic layer 27 is disposed on the light absorptive metal layer 25, and the transparent protective layer 30 is formed thereon, as shown in FIG. 2. It is estimated that an improvement of the adhesion between the transparent protective layer 30 and the metal oxide layer 27 is derived from the fact that an acid group in the ester compound exhibits high compatibility with a metal oxide, and in particular, a hydroxyl group of phosphoric acid in the phosphate ester compound has excellent compatibility with a metal oxide layer, thereby improving the adhesion.

From the viewpoint of enhancing mechanical strength and chemical strength of the transparent protective layer 30, the above ester compound preferably contains a (meth)acryloyl group as the polymerizable functional group. Further, from the viewpoint of facilitating introduction of the cross-linked structure, the above ester compound may have a plurality of polymerizable functional groups in the molecule. As the above ester compound, for example, a phosphate monoester compound or a phosphate diester compound represented by the following formula (1) is suitably used. The phosphate monoester may be used in combination with the phosphate diester. 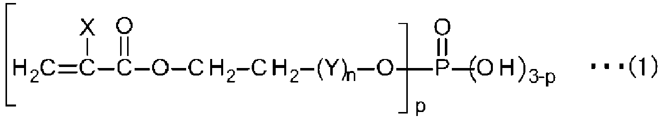 In the above formula, X represents a hydrogen atom or a methyl group, and (Y) represents a -OCO(CH₂)₅- group. n is 0 or 1, p is 1 or 2.

The content of the structure derived from the above ester compound in the transparent protective layer 30 is preferably 1 to 20 wt%, more preferably 1.5 to 17.5 wt%, further preferably 2 to 15 wt%, and particularly preferably 2.5 to 12.5 wt%. When the content of the structure derived from the ester compound is excessively small, the effect of improving the strength or the adhesion may not be adequately achieved. On the other hand, when the content of the structure derived from the ester compound is excessively large, a curing rate during formation of the transparent protective layer may be low, resulting in a reduction of the hardness of the layer, or slip properties of the surface of the transparent protective layer may be deteriorated, resulting in a reduction of abrasion-resistance. The content of the structure derived from the ester compound in the transparent protective layer can be set to a desired range by adjusting the content of the above ester compound in a composition in formation of the transparent protective layer.

A method for forming the transparent protective layer 30 is not particularly limited. The transparent protective layer is preferably formed by dissolving, for example, an organic resin, or a curable monomer or an oligomer of an organic resin and the above-mentioned ester compound in a solvent to prepare a solution, applying the solution onto the light absorptive metal layer 25 or the transparent inorganic layer 27, removing the solvent by evaporation, and curing the rest by ultraviolet or electron irradiation or addition of heat energy.

The material of the transparent protective layer 30 may include additives such as coupling agents (silane coupling agent, titanium coupling agent, etc.), leveling agents, ultraviolet absorbers, antioxidants, heat stabilizers, lubricants, plasticizers, coloring inhibitors, flame retarders and antistatic agents in addition to the above-mentioned organic materials, inorganic materials and ester compounds. The contents of these additives can be appropriately adjusted to an extent which does not impair the object of the present invention.

As described above, in the infrared reflecting substrate according to the present invention, the absorption of light by the light absorptive metal layer and the effect of preventing reflection by the transparent protective layer are combined together to reduce the visible light reflectance to improve the visibility. Therefore, there is no need to form a metal oxide layer having a large thickness, which can function as a spacer layer of Fabry-Pérot interference, between the light absorptive metal layer 25 and the transparent protective layer 30, so that the productivity of the infrared reflecting substrate is enhanced.

### [Layer Configuration between Light Absorptive Reflecting Layer and Transparent Protective Layer]

In the infrared reflecting substrate of the present invention, a layer configuration thereof is not particularly limited as long as the distance t between the light absorptive metal layer 25 and the transparent protective layer 30 is 25 nm or less. Referring to FIG. 2, the transparent protective layer 30 may be formed directly on the light absorptive metal layer 25. Alternatively, referring to FIG. 1, a transparent inorganic layer 27 or the like may be formed between the light absorptive metal layer 25 and the transparent protective layer 30. Further, a plurality of metal layers, transparent inorganic layers and the like may be formed between the light absorptive metal layer 25 and the transparent protective layer 30. From the viewpoint of enhancing the productivity of the infrared reflecting substrate, the layer formed between the light absorptive metal layer 25 and the transparent protective layer 30 is preferably a single-layer. The distance t between the light absorptive metal layer 25 and the transparent protective layer 30 is preferably 20 nm or less, more preferably 15 nm or less, and further preferably 10 nm or less. The minimum value of the thickness of the transparent inorganic layer 27 is zero, so that t the transparent protective layer 30 may be formed directly on the light absorptive metal layer 25 as shown in FIG. 2.

### <Transparent Inorganic Layer>

When the infrared reflecting substrate 101 is provided with a transparent inorganic layer 27 between the light absorptive metal layer 25 and the transparent protective layer 30, a material mainly made of a metal oxide, a metal nitride, a metal oxide nitride and the like is preferably used as a material of the transparent inorganic layer 27.

Examples of the metal oxide that can be used for constituting the transparent inorganic layer 27 include oxides of In, Zn, Sn, Al, Ga, Tl, Ti, Zr, Hf, Ce, Sb, V, Nb, Ta, Si, Ge, and the like, and composite oxides thereof (for example, indium tin oxide (ITO), indium zinc oxide (IZO), zinc tin oxide (ZTO), aluminum-doped zinc oxide (AZO), gallium-doped zinc oxide (GZO), antimony-doped tin oxide (ATO)), and the like. As the metal nitride, for example, silicon nitride is preferably used. As the oxide nitride, an inorganic material such as silicon oxide nitride or sialon (SiAlON) is preferably used.

Although the method for forming the transparent inorganic layer 27 is not particularly limited; a dry process such as a sputtering method, a vacuum vapor deposition method, a CVD method, or an electron beam vapor deposition method is preferred. Among these, the transparent inorganic layer 27 is preferably formed by a sputtering method and, from the viewpoint of productivity, the transparent inorganic layer 27 is particularly preferably formed by DC sputtering. In the case where the transparent substrate 10 is a flexible film and all of the infrared reflecting layer 23, the light absorptive metal layer 25 and the transparent inorganic layer 27 are deposited by DC sputtering, it is effective to use a roll-to-roll sputtering apparatus provided with a plurality of deposition chambers since these layers can be formed in one path process. Therefore, the productivity of the infrared reflecting substrate can be greatly improved.

The transparent inorganic layer 27 can function as a protective layer for protecting the infrared reflecting layer 23 and the light absorptive metal layer 25. For example, the transparent inorganic layer 27 functions as a gas barrier layer against oxygen and the like, and can perform a function of suppressing oxidation degradation of the infrared reflecting layer 23 and the light absorptive metal layer 25. Further, by improving adhesion between the light absorptive metal layer 25 and the transparent protective layer 30, the transparent inorganic layer 27 may also have a function of improving the performance of protecting the infrared reflecting layer 23 and the light absorptive metal layer 25 that is provided by the transparent protective layer 30.

Among these, as described above, in the case where the transparent protective layer 30 has a cross-linked structure derived from a phosphate ester compound and the transparent inorganic layer 27 is a metal oxide, the adhesion is greatly improved, and the durability of the infrared reflecting substrate tends to be enhanced. In particular, when the metal oxide constituting the transparent inorganic layer 27 is a composite metal oxide containing zinc oxide and tin oxide, the durability of the infrared reflecting substrate tends to be considerably improved since the chemical durability of the metal oxide itself is high and is excellent in adhesion to the transparent protective layer.

When the transparent inorganic layer (metal oxide layer) 27 is made of a composite metal oxide containing zinc oxide and tin oxide, the content of zinc atoms in the metal oxide layer is preferably 10 atom% to 60 atom%, more preferably 15 atom% to 50 atom%, and further preferably 20 atom% to 40 atom%, with respect to the total amount of metal atoms. When the content of zinc atoms (zinc oxide) is small, the metal oxide layer becomes crystalline, and the durability may decrease. Further, when the content of zinc atoms (zinc oxide) is small, the resistance tends to become high, so that the electric conductivity of a sputtering target in depositing the metal oxide layer by a sputtering method tends to decrease, making it difficult to deposit the metal oxide layer by DC sputtering. On the other hand, when the content of zinc atoms is excessively large, the adhesion to the light absorptive metal layer 25 or the transparent protective layer 30 may decrease.

The content of tin atoms in the metal oxide layer 27 is preferably 30 atom% to 90 atom%, more preferably 40 atom% to 85 atom%, and further preferably 50 atom% to 80 atom%, with respect to the total amount of metal atoms. When the content of tin atoms (tin oxide) is excessively small, the chemical durability of the metal oxide layer tends to decrease. On the other hand, when the content of tin atoms (tin oxide) is excessively large, the resistance of the sputtering target used in deposition tends to become high, making it difficult to deposit the metal oxide layer by a DC sputtering method.

The metal oxide layer 27 may contain metals such as Ti, Zr, Hf, Nb, Al, Ga, In, Tl and Ga or metal oxides thereof in addition to zinc oxide and tin oxide. These metals or metal oxides can be added for the purpose of raising the electric conductivity of the target at the time of sputtering deposition to increase the deposition rate, enhancing the transparency of the metal oxide layer or the like purpose. A sum of the content of oxidized atoms and the content of tin atoms in the metal oxide layer is preferably 40 atom% or more, more preferably 50 atom% or more, and further preferably 60 atom% or more, with respect to the total amount of metal atoms.

The thickness of the metal oxide layer 27 is preferably 2 nm or more, and more preferably 3 nm or more. When the thickness is 2 nm or more, the coverage of the metal oxide layer 27 on the light absorptive metal layer 25 becomes good, so that the adhesion tends to be enhanced. The thickness of the metal oxide layer 27 is 25 nm or less. A large thickness of the metal oxide layer leads to increase in the deposition time to reduce productivity. Further, when the thickness of the metal oxide layer is excessively increased, the adhesion rather tends to decrease. Therefore, the thickness of the metal oxide layer 27 is preferably as small as possible within a range that can ensure the adhesion between the metal layer and the transparent protective layer. Specifically, the thickness of the metal oxide layer 27 is preferably 15 nm or less, more preferably 10 nm or less, and further preferably 8 nm or less.

As described above, the metal oxide layer made of a composite metal oxide containing zinc oxide and tin oxide is preferably deposited by a DC sputtering method, and in particular, the metal oxide layer is preferably deposited by a DC sputtering method using a target containing a metal and a metal oxide. Since zinc oxide and tin oxide (particularly, tin oxide) have low electrical conductivity, a metal oxide target formed by sintering only these metal oxides has low electrical conductivity. When such a target is used for DC sputtering, there is a tendency that discharge does not occur or performing deposition stably for a long time is difficult.

The target containing a metal and a metal oxide can be formed by sintering a metal of preferably 0.1 wt% to 20 wt%, more preferably 0.2 wt% to 15 wt%, together with zinc oxide and/or tin oxide. When the metal content at the time of forming the target is excessively small, the electric conductivity of the target becomes insufficient, whereby the deposition by DC sputtering may become difficult, or the adhesion between the metal oxide layer and the infrared reflecting layer or the like may decrease. When the metal content at the time of forming the target is excessively large, the amount of a remaining metal unoxidized during the sputtering deposition or the amount of a metal oxide whose oxygen content is less than the stoichiometric composition is increased, and this tends to cause a reduction of visible light transmittance of the metal oxide layer. A metal powder in the target forming material may be a powder of metal other than metal zinc and metal tin; however, the target forming material preferably contains at least any one among metal zinc and metal tin, and particularly preferably contains metal zinc. Since the metal powder used in the target forming material is oxidized by sintering, the metal powder in the target forming material may exist as a metal oxide in a sintered target.

When the metal oxide layer is formed by sputtering method, inside of the sputtering chamber is evacuated, and then sputtering deposition is performed while introducing an inert gas such as Ar, and oxygen into the sputtering chamber. The amount of oxygen introduced into the deposition chamber in formation of the metal oxide layer is preferably 8 vol% or less, more preferably 5 vol% or less, and further preferably 4 vol% or less with respect to the total flow rate of the introduced gas. By reducing the oxygen introduction amount, oxidation of the light absorptive metal layer or the infrared reflecting layer 23 serving as an underlay of the metal oxide layer 27 is suppressed. Further, by reducing the oxygen introduction amount at the time of depositing the metal oxide layer 27, the adhesion of the metal oxide layer 27 to the light absorptive metal layer 25 tends to be enhanced. The reason why the adhesion between the metal oxide layer and the metal layer is enhanced is not clear, it is estimated that the following contributes to an improvement of the adhesion. Since sputtering is performed under insufficient oxygen condition in which oxygen amount is insufficient for oxidizing a metal in the target to form a metal oxide having stoichiometric composition (zinc oxide (ZnO) and/or tin oxide (SnO₂)), obtained metal oxide layer contains a remaining metal or a metal oxide having insufficient oxygen in which the oxygen content is less than the stoichiometric composition. The oxygen introduction amount refers to an amount (vol%) of oxygen introduced into a deposition chamber, in which a target to be used for deposition of the metal oxide layer is placed, with respect to the total amount of the gas introduced into the deposition chamber. When a sputtering deposition apparatus including a plurality of deposition chambers divided by a closure plate is employed, the oxygen introduction amount is calculated based on the amount of gas introduced into each divided deposition chamber.

On the other hand, when the oxygen introduction amount during sputtering deposition is excessively small, an amount of the metal oxide having insufficient oxygen increases, and this tends to cause a reduction of visible light transmittance. Therefore, the amount of oxygen introduced into the deposition chamber during sputtering deposition is preferably 0.1 vol% or more, more preferably 0.5 vol% or more, and further preferably 1 vol% or more with respect to the total flow rate of the introduced gas.

In addition, when the zinc tin oxide (ZTO) is deposited by DC sputtering with introduction of a specific amount of oxygen and using the above-mentioned target, there is an advantage that a particle generation (adhesion) on the target during continuous deposition is less than the case of depositing ITO, IZO or the like as a metal oxide. If particles adhere to the surface of the target, abnormal discharge or contamination inside the sputtering apparatus occurs, so that a film with stable quality is unable to be obtained. Therefore, when particles adhere to the surface of the target, deposition operation is once stopped, and maintenance work such as polishing of the target surface or cleaning of sputtering apparatus, is required. Further, it also takes time to bring the sputtering chamber into vacuum in restarting deposition after the maintenance.

Since the adhesion of particles to the target surface during deposition is suppressed and a maintenance interval is lengthened (maintenance frequency is reduced), the production efficiency of the infrared reflecting substrate can be improved. Particularly, when continuous deposition by a roll-to-roll sputtering apparatus is performed, since maintenance frequency of the sputtering apparatus can be decreased to increase a continuous deposition length, productivity can be outstandingly improved.

A substrate temperature during deposition of the metal oxide layer 27 by sputtering is preferably lower than a heatresistant temperature of the transparent film substrate. The substrate temperature is preferably, for example, 20°C to 160°C, and more preferably 30°C to 140°C. A power density during sputtering deposition is preferably, for example, 0.1 W/cm² to 10 W/cm², more preferably 0.5 W/cm² to 7.5 W/cm², and further preferably 1 W/cm² to 6 W/cm². A process pressure during deposition is preferably, for example, 0.01 Pa to 10 Pa, more preferably 0.05 Pa to 5 Pa, and further preferably 0.1 Pa to 1 Pa. When the process pressure is excessively high, a deposition rate tends to decrease, and in contrast, when the pressure is excessively low, discharge tends to be unstable.

### [Layer Configuration between Transparent Substrate and Infrared Reflecting Layer]

The layer configuration between the transparent substrate 10 and the infrared reflecting layer 23 is not particularly limited. The infrared reflecting layer 23 may be formed directly on the transparent substrate 10, or alternatively, the infrared reflecting layer 23 may be formed on the transparent substrate 10 with another layer interposed between the infrared reflecting layer 23 and the transparent substrate 10.

A metal layer, a metal oxide layer or the like may be disposed between the transparent substrate 10 and the infrared reflecting layer 23 for the purpose of, for example, improving the durability, improving the adhesion or making optical adjustments, of the infrared reflecting layer and the like. For example, referring to FIGS. 1 and 2, when a metal oxide layer 21 is disposed between the transparent substrate 10 and the infrared reflecting layer 23, the adhesion between the two can be improved, and a further improved durability can be imparted to the infrared reflecting substrate.

### <Metal Oxide Layer>

As a material of the metal oxide layer 21 disposed between the transparent substrate 10 and the infrared reflecting layer 23, metal oxides exemplified above as a material constituting the transparent inorganic layer 27 are preferably used. In particular, by disposing a composite metal oxide layer containing zinc oxide and tin oxide between the transparent substrate 10 and the infrared reflecting layer 23, the adhesion between the transparent substrate 10 and the infrared reflecting layer 23 tends to be enhanced.

In conventional methods, a metal layer such as Ni-Cr is disposed as an under layer adjacent to the infrared reflecting layer to enhance adhesion to the substrate or the like, for the purpose of enhancing adhesion between the infrared reflecting layer made of silver or the like. However, when a finger fat component or the like penetrates into the infrared reflecting substrate, releasing may occur at the interface between the metal layer of Ni-Cr or the like and the substrate. In contrast, by forming the infrared reflecting layer 23 on the transparent substrate 10 with a metal oxide layer 21 of ZTO or the like interposed therebetween, the adhesion is enhanced, and also the chemical durability is enhanced. Therefore, even when a finger fat component or the like penetrates, releasing at the interface hardly occurs, so that the durability of the infrared reflecting substrate tends to be enhanced.

Although the method for forming the metal oxide layer 21 is not particularly limited, a dry process such as a sputtering method, a vacuum vapor deposition method, a CVD method or an electron-beam deposition method is preferred. Particularly, it is preferred to form the metal oxide layer 21 by the sputtering method, and a DC sputtering method is especially preferred from the viewpoint of productivity. When a composite metal oxide layer containing zinc oxide and tin oxide is formed as the metal oxide layer 21, conditions similar to those described above with respect to the metal oxide layer 27 are preferably adopted as the composition and the method of deposition of the composite metal oxide layer.

A further different layer may be provided each between the transparent substrate 10 and the metal oxide layer 21 and between the metal oxide layer 21 and the infrared reflecting layer 23. It is preferable that the infrared reflecting substrate of the present invention does not have a metal layer between the transparent substrate 10 and the infrared reflecting layer 23. As described above, by providing a metal oxide layer 21 of ZTO or the like on the transparent substrate 10, the adhesion between the transparent substrate 10 and the infrared reflecting layer 23 is enhanced, so that there is no particular need to provide a metal layer (under layer) such as Ni-Cr. Since no metal layer is disposed between the transparent substrate 10 and the infrared reflecting layer 23, the visible light transmittance of the infrared reflecting substrate can be improved. Further, there is no need to form a metal layer between the transparent substrate 10 and the infrared reflecting layer 23, so that the number (kinds) of thin films constituting the infrared reflecting substrate as well as the total thickness thereof are reduced, thereby enhancing the productivity of the infrared reflecting substrate.

From the viewpoint of improving the productivity, the layer formed between the transparent substrate 10 and the infrared reflecting layer 23 is preferably a single-layer. From the viewpoint of improving the adhesion, it is preferable that the transparent substrate 10 and the metal oxide layer 21 are in direct contact with each other. Similarly, it is preferable that the metal oxide layer 21 and the infrared reflecting layer 23 are in direct contact with each other. To sum up these, in the infrared reflecting substrate of the present invention, it is preferable that the metal oxide layer 21 is formed on the transparent substrate 10 so as to be in direct contact with the transparent substrate 10, and the infrared reflecting layer 23 is formed directly on the metal oxide layer 21.

### [Properties of Infrared Reflecting Substrate]

In the infrared reflecting substrate of the present invention, a normal emittance measured from the transparent protective layer 30 side is preferably 0.20 or less, more preferably 0.15 or less, further preferably 0.12 or less, and particularly preferably 0.10 or less.

The visible light transmittance of the infrared reflecting substrate is preferably 15% or more, more preferably 20% or more, further preferably 25% or more, and particularly preferably 30% or more. In the meantime, from the viewpoint of enhancing the heat shielding properties, the visible light transmittance is preferably 50% or less, more preferably 45% or less, and further preferably 40% or less. As described above, when the infrared reflecting substrate has a configuration in which the light absorptive metal layer 25 is provided only between the infrared reflecting layer 23 and the transparent protective layer 30 and having no light absorptive metal layer between the transparent substrate 10 and the infrared reflecting layer 23, reflection of visible light can be suppressed while absorption of visible light is suppressed, thereby setting the visible light transmittance to be within the above-mentioned range. In the infrared reflecting substrate of the present invention, the visible light reflectance is preferably 40% or less, more preferably 35% or less, and further preferably 30% or less.

### [Usage]

As described above, the infrared reflecting substrate of the present invention includes the infrared reflecting layer 23, the light absorptive metal layer 25 and the transparent protective layer 30 on one main surface of the transparent substrate 10, and may include other layers between these layers in accordance as necessary. The infrared reflecting substrate of the present invention can be used for windows of buildings, vehicles or the like, transparent cases for botanical companions or the like, or showcases of freezing or cold storage, to cause the effects of cooling/heating and to prevent rapid changes in temperature.

As described before with reference to FIG. 3, the infrared reflecting film 100 of the present invention produces a heat-shielding effect and a heat insulating effect by transmitting and introducing indoors the visible light (VIS) from the outdoors and reflecting the near-infrared rays (NIR) from the outdoors with the infrared reflecting layer 23. Further, the infrared reflecting substrate of the present invention has a light absorptive metal layer and thus visible light reflectance is reduced. When the infrared reflecting substrate is used for a display case, a store window or the like, the heat shielding properties and the heat insulating properties can be imparted without degrading the visibility of commercial products and the like.

When the transparent substrate 10 is a rigid body such as a glass plate, the infrared reflecting substrate can be inserted and fitted into a frame body or the like as it is, so as to form a heat-shielding and heat-insulating window. When the transparent substrate 10 is a flexible film, the infrared reflecting substrate is preferably used with bonded to a rigid substrate such as a window glass. It is to be noted that the infrared reflecting substrate having a rigid body transparent substrate may also be put into use with bonded to another rigid body such as a window glass.

A surface opposite to the infrared reflecting layer 23-forming surface of the transparent substrate 10 may be provided with an adhesive layer 60 or the like to be used for bonding the infrared reflecting substrate to a window glass or the like. As the adhesive layer, an adhesive having a high visible light transmittance and a small difference in refractive index with the transparent substrate 10 is suitably used. For example, an acryl-based pressure sensitive adhesive is suitable as a material of the adhesive layer provided for the transparent film substrate, since it has excellent optical transparency, exhibits appropriate wettability, cohesive property, and adhesion properties, and is excellent in weatherability and heat resistance.

The adhesive layer preferably has a high visible light transmittance and low ultraviolet transmittance. The degradation of the infrared reflecting layer caused by ultraviolet rays of the sunlight or the like can be suppressed by reducing the ultraviolet transmittance of the adhesive layer. From the viewpoint of reducing the ultraviolet transmittance of the adhesive layer, the adhesive layer preferably contains an ultraviolet absorber. The degradation of the infrared reflecting layer caused by ultraviolet rays from the outdoors can also be suppressed by using a transparent film substrate containing an ultraviolet absorber. An exposed surface of the adhesive layer is preferably temporarily attached with a separator to be covered for the purpose of preventing the contamination of the exposed surface until the infrared reflecting substrate is put into practical use. This can prevent the contamination of the exposed surface of the adhesive layer due to contact with external during usual handling.

The infrared reflecting substrate may also be used by being inserted and fitted into a frame body or the like as disclosed, for example, in JP 2013-61370 A, even when the transparent substrate 10 is a flexible film. In this usage, there is no need to add and attach an adhesive layer to the transparent substrate 10, so that absorption of far-infrared rays by the adhesive layer does not occur. Therefore, by using a material (for example, cyclic polyolefin) having a small content of functional groups such as a C=C bond, a C=O bond, a C-O bond or an aromatic ring as the transparent substrate 10, the far-infrared rays from the transparent substrate 10 side can be reflected by the infrared reflecting layer 23, so that the heat insulating properties can be imparted to both sides of the infrared reflecting substrate. Such a configuration is particularly useful, for example, in a cold-storage display case, a freezer display case or the like.

### EXAMPLE

The present invention will be described more specifically below by showing examples, but the present invention is not limited to these examples.

### [Measuring Methods Applied in the Examples and Comparative Examples]

### <Thickness of Each Layer>

A thickness of each of the metal layer, metal oxide layer and the transparent protective layer was determined by machining a sample by a focused ion beam (FIB) method using a focused ion beam machining observation device (manufactured by Hitachi, Ltd., trade name "FB-2100"), and observing a cross-section of the sample using a field emission transmission electron microscope (manufactured by Hitachi, Ltd., trade name "HF-2000"). Thickness of the hard coat layer formed on the substrate was determined by calculation from an interference pattern of visible light reflectance in allowing light to enter from a measuring object side by using an instantaneous multi-photometric system (manufactured by Otsuka Electronics Co., Ltd., trade name "MCPD3000").

### <Visible Light Transmittance and Reflectance >

The visible light transmittance and reflectance were measured by using a spectral photometer (trade name "U-4100" manufactured by Hitachi High-Technologies Corporation). In measurement, a surface on a transparent film substrate side of an infrared reflecting film was bonded to a 3mm thick glass plate with a 25µm thick pressure sensitive adhesive layer interposed therebetween to form a sample for measurement. The infrared reflecting substrate of Example 1 was used, as it was, as a measurement sample without being bonded to a glass plate. The transmittance was calculated in accordance with a transmittance calculation method of JIS A5759-2008 (Adhesive films for glazings). Regarding the reflectance, light was made to be incident at an incidence angle of 5° from the transparent protective layer side, and a 5° absolute reflectance within a wavelength range of 380 nm to 780 nm was measured.

### [Example 1]

In Example 1, an infrared reflecting substrate including a metal oxide layer made of ZTO, an Ag-Pd metal layer (infrared reflecting layer) and a Ni-Cr metal layer on a glass substrate and further having a transparent resin protective layer thereon was prepared by a method described below.

On a glass substrate, a zinc-tin composite oxide (ZTO) layer having a thickness of 4 nm, an Ag-Pd alloy layer (infrared reflecting layer) having a thickness of 16 nm, a Ni-Cr alloy layer having a thickness of 5 nm, and a ZTO layer having a thickness of 4 nm were formed in this order by a DC magnetron sputtering method using a parallel plate type sputtering apparatus. A target formed by sintering zinc oxide, tin oxide and metal zinc powder in a weight ratio of 8.5 : 83 : 8.5 was used for deposition of the ZTO layer, and sputtering was carried out under conditions with a power density of 2.67 W/cm², a process pressure of 0.4 Pa and a substrate temperature of 80°C. During the deposition, the gas introduction amount into the sputtering deposition chamber was adjusted so that the ratio Ar : O₂ would be 98 : 2 (volume ratio). A metal target containing silver : palladium in a weight ratio of 96.4 : 3.6 was used for deposition of the Ag-Pd layer. A metal target containing nickel : chromium in a weight ratio of 80 : 20 was used for deposition of the Ni-Cr layer.

### (Formation of Transparent Resin Protective Layer)

On the ZTO layer, a transparent resin protective layer composed of a fluorine-based ultraviolet-curable resin having a cross-linked structure derived from a phosphate ester compound was formed in a thickness of 70 nm. Specifically, a solution prepared by adding 5 parts by weight of a phosphate ester compound (manufactured by Nippon Kayaku Co., Ltd., trade name "KAYAMER PM-21") to 100 parts by weight of a solid content of an acryl-based hard coat resin solution (trade name "OPSTAR Z7540", manufactured by JSR Corporation) was applied by using an applicator, dried at 60°C for 1 minute, and irradiated with ultraviolet rays of accumulated light quantity of 400 mJ/cm² by an ultra-high pressure mercury lamp in a nitrogen atmosphere to be cured. Refractive index of the cured resin protective layer was 1.5. The phosphate ester compound above is a mixture of a phosphate monoester compound (compound represented by the formula (1), wherein X is a methyl group, n = 0, and p = 1) having one acryloyl group in one molecule and a phosphate diester compound (compound represented by the formula (1), wherein X is a methyl group, n = 0, and p = 2) having two acryloyl groups in one molecule.

### [Example 2]

In Example 2, as the transparent substrate, a polyethylene terephthalate (PET) film having a thickness of 50 µm (manufactured by Toray Industries, Inc., trade name "Lumirror U48", visible light transmittance of 93%) was used in place of the glass plate. The metal oxide layer and the metal layer were deposited by using a roll-to-roll sputtering apparatus. An infrared reflecting film including a ZTO metal oxide layer, an Ag-Pd metal layer, a Ni-Cr metal layer, a ZTO metal oxide layer and a transparent resin protective layer in this order on a film substrate was prepared in the same manner as in Example 1 except for the above changes.

### [Example 3]

In Example 3, a PET film provided with a hard coat layer on a surface was used as the transparent substrate. An acrylic-based ultraviolet-curing type hard coat layer (manufactured by Nippon Soda Co., Ltd., NH2000G) was formed so as to have a thickness of 2 µm on one surface of the PET film. In more detail, a hard coat solution was applied by a gravure coater, dried at 80°C, and irradiated with ultraviolet rays of accumulated light quantity of 300 mJ/cm² by an ultra-high pressure mercury lamp to be cured.

On the surface of this PET film having the hard coat layer on the side where the hard coat layer had been formed, a ZTO metal oxide layer, an Ag-Pd metal layer, a Ni-Cr metal layer and a ZTO metal oxide layer were deposited using a roll-to-roll sputtering apparatus in the same manner as in Example 2, and thereafter a transparent resin protective layer was formed thereon.

### [Example 4]

An infrared reflecting film was prepared in the same manner as in Example 3 except that the ZTO metal oxide layer was not formed on the Ni-Cr metal layer.

### [Examples 5 and 6]

Infrared reflecting films were prepared in the same manner as in Example 4 except that the thicknesses of the Ni-Cr metal layers were changed as shown in Table 1.

### [Example 7]

Infrared reflecting film was prepared in the same manner as in Example 3 except that the thickness of the ZTO metal oxide layer on the Ni-Cr metal layer was changed to 15 nm.

### [Example 8]

Infrared reflecting film was prepared in the same manner as in Example 7 except that the thickness of the resin protective layer was changed to 10 nm.

### [Comparative Example 1]

An infrared reflecting film was prepared in the same manner as in Example 3 except that the resin protective layer was not formed on the ZTO metal oxide layer.

### [Comparative Examples 2 and 3]

Infrared reflecting films were prepared in the same manner as in Example 4 except that the thicknesses of the resin protective layers were changed as shown in Table 1.

### [Comparative Example 4]

Infrared reflecting film was prepared in the same manner as in Example 4 except that the thickness of the Ni-Cr metal layer was changed to 20 nm.

### [Comparative Example 5]

Infrared reflecting film was prepared in the same manner as in Example 3 except that the thickness of ZTO metal oxide layer on the Ni-Cr metal layer was changed to 30 nm.

### [Evaluation]

Stacking configuration and measurement results of the reflectance and transmittance of the infrared reflecting substrate (infrared reflecting film) of each of Examples and Comparative Examples described above are shown in Table 1. In the layer configuration shown in Table 1, a value in parentheses represents a thickness of each layer in nanometers.

**[Table 1]**

| | Substrate | Thin-film stacking configuration | Transparent resin layer | | Reflectance (%) | Transmittance (%) |
|---|---|---|---|---|---|---|
| | | | Thickness (nm) | Optical thickness (nm) | | |
| Example 1 | glass | ZTO (4) / Ag-Pd (16) / Ni-Cr (5) / ZTO (4) | 70 | 105 | 23 | 31 |
| Example 2 | PET | ZTO (4) /Ag-Pd (16) / Ni-Cr (5) / ZTO (4) | 70 | 105 | 23 | 31 |
| Example 3 | PET/HC | ZTO (4) /Ag-Pd (16) / Ni-Cr (5) / ZTO (4) | 70 | 105 | 23 | 31 |
| Example 4 | PET/HC | ZTO (4) /Ag-Pd (16) / Ni-Cr (5) | 70 | 105 | 25 | 30 |
| Example 5 | PET/HC | ZTO (4) /Ag-Pd (16) / Ni-Cr (2) | 70 | 105 | 29 | 45 |
| Example 6 | PET/HC | ZTO (4) /Ag-Pd (16) / Ni-Cr (10) | 70 | 105 | 28 | 17 |
| Example 7 | PET/HC | ZTO (4) /Ag-Pd (16) / Ni-Cr (5) / ZTO (15) | 70 | 105 | 18 | 33 |
| Example 8 | PET/HC | ZTO (4) /Ag-Pd (16) / Ni-Cr (5) / ZTO (15) | 10 | 15 | 28 | 28 |
| Comparative Example 1 | PET/HC | ZTO (4) /Ag-Pd (16) / Ni-Cr (5) / ZTO (4) | - | | 48 | 22 |
| Comparative Example 2 | PET/HC | ZTO (4) /Ag-Pd (16) / Ni-Cr (5) | 150 | 225 | 39 | 25 |
| Comparative Example 3 | PET/HC | ZTO (4) /Ag-Pd (16) / Ni-Cr (5) | 5 | 8 | 48 | 21 |
| Comparative Example 4 | PET/HC | ZTO (4) /Ag-Pd (16) / Ni-Cr (20) | 70 | 105 | 35 | 11 |
| Comparative Example 5 | PET/HC | ZTO (4) /Ag-Pd (16) / Ni-Cr (5) / ZTO (30) | 70 | 105 | 16 | 32 |

In all of the infrared reflecting films of Examples of the present invention, the distance between the Ni-Cr layer and the resin protective layer (transparent protective layer) is 25 nm or less, and the visible light reflectance is suppressed to be less than 30% despite the fact that the ZTO layers of Examples 1 to 3, 7 and 8 do not have a thickness large enough to allow selective transmission of visible light as a spacer layer of the Fabry-Pérot interference stack.

Even though the kind of the transparent substrate was changed in Examples 1 to 3, the visible light transmittance and reflectance each showed an almost equal value in these Examples. On the other hand, it will be understood that the reflectance is reduced by the transparent protective layer in the infrared reflecting substrate of the present invention, from the comparison between Example 3 and Comparative Example 1 (no transparent protective layer). Further, it will be understood that the reflectance is reduced by adjusting the (optical) thickness of the transparent protective layer from the comparison between Example 4 and Comparative Examples 2 and 3 or from comparison between Example 7 and Example 8.

The reflectance was almost equal in Examples 4 to 6 (the thickness of the Ni-Cr layer being 2 nm to 10 nm), and a tendency was seen such that the transmittance increased by increase of light absorption according as the thickness of the Ni-Cr layer increased. On the other hand, in Comparative Example 4 in which the thickness of the Ni-Cr layer was 20 nm, the reflectance increased as compared with Examples 4 to 6 despite the fact that the transmittance was as low as 11%. From these results, it can be stated that the thickness of the light absorptive metal layer is preferably 15 nm or less and as small as possible within a range that can exert the protecting function on the infrared reflecting layer.

Comparative Example 5 in which the thickness of the ZTO metal oxide layer was 30 nm showed a low reflectance; however, since the thickness of the metal oxide layer was large, it took a long period of time for deposition by sputtering, and the productivity was low. From the above results, it will be understood that, according to the present invention, an anti-reflection effect almost equal to one having the metal oxide layer with increased thickness can be obtained without degrading the productivity by adjusting the (optical) thickness of the transparent protective layer formed as a top coat.

### DESCRIPTION OF REFERENCE CHARACTERS

- 100, 101, 102:: infrared reflecting substrate
- 10:: transparent substrate
- 11:: transparent film
- 12: cured resin layer
- 21:: metal oxide layer
- 23:: infrared reflecting layer
- 25:: light absorptive metal layer
- 27:: transparent inorganic layer (metal oxide layer)
- 30:: transparent protective layer
- 60:: adhesive layer

## Claims

1. An infrared reflecting substrate comprising: an infrared reflecting layer mainly made of silver; a light absorptive metal layer; and a transparent protective layer, in this order on a transparent substrate, wherein
a thickness of the light absorptive metal layer is 15 nm or less,
a thickness of the transparent protective layer is 10 nm to 120 nm, and
a distance between the light absorptive metal layer and the transparent protective layer is 25 nm or less.

2. The infrared reflecting substrate according to claim 1, wherein the transparent protective layer has an optical of 50 nm to 150 nm, the optical thickness being defined as a product of refractive index and thickness.

3. The infrared reflecting substrate according to claim 1 or 2, wherein the light absorptive metal layer is mainly made of nickel, chromium, or a nickel-chromium alloy.

4. The infrared reflecting substrate according to any one of claims 1 to 3, wherein the infrared reflecting layer is a silver alloy layer containing 0.1 parts by weight to 10 parts by weight of palladium with respect to 100 parts by weight of silver.

5. The infrared reflecting substrate according to any one of claims 1 to 4, wherein the light absorptive metal layer and the transparent protective layer are in direct contact with each other.

6. The infrared reflecting substrate according to any one of claims 1 to 4, further comprising a transparent inorganic layer between the light absorptive metal layer and the transparent protective layer, the transparent inorganic layer is mainly made of a metal oxide, a metal nitride, or a metal oxide nitride, and
the transparent inorganic layer and the transparent protective layer are in direct contact with each other.

7. The infrared reflecting substrate according to claim 6, wherein the transparent inorganic layer and the metal layer are in direct contact with each other.

8. The infrared reflecting substrate according to claim 6 or 7, wherein the transparent inorganic layer is formed of a composite metal oxide containing zinc oxide and tin oxide.

9. The infrared reflecting substrate according to any one of claims 1 to 8, wherein the transparent protective layer is an organic layer including a cross-linked structure derived from an ester compound having an acidic group and a polymerizable functional group in one molecule, and
a content of the structure derived from the ester compound in the transparent protective layer is 1 wt% to 20 wt%.

10. The infrared reflecting substrate according to claim 9, wherein the ester compound is an ester of phosphoric acid and an organic acid having a polymerizable functional group.

11. The infrared reflecting substrate according to any one of claims 1 to 10, wherein the transparent substrate is a flexible transparent film.

12. The infrared reflecting substrate according to any one of claims 1 to 11, having a visible light transmittance of 15% to 50%.
